# EUROPEAN PATENT APPLICATION

(11) **EP 4 778 977 A1**
(43) Date of publication of application: **22.07.2026**
(21) Application number: 24865745.4
(22) Date of filing: 02.09.2024
(51) Int. Cl.: C08L 63/00, C08L 83/06, C08G 77/14, C08G 77/00, H01L 23/29

(54) **EPOXY RESIN COMPOSITION FOR MOLDING**

(30) Priority: 11.09.2023 KR 20230120634
(71) Applicant: Momentive Performance Materials Inc., Niskayuna, NY 12309 (US)
(72) Inventor: KIM, Seung Taek, Yongin-si, Gyeonggi-do 16998 (KR); KONG, Byung Seon, Yongin-si, Gyeonggi-do 17013 (KR); SHIM, Myoung Taek, Gwangju 62246 (KR); LEE, Eun Han, Yongin-si, Gyeonggi-do 16891 (KR); IJIMA, Yoichiro, Fujisawa City, Kanagawa 251-0021 (JP); MOCHIZUKI, Kyohei, Yokohama City, Kanagawa 222--0011 (JP); SASAKI, Motoshi, Ohta City, Gunma 3700841 (JP); PHUKAN, Monjit, Harrison, New York 10604 (US)
(74) Representative: Pfenning, Meinig & Partner mbB
(86) International application number: PCT/KR2024/013136
(87) International publication number: WO 2025/058304

(57) **Abstract**

The present invention relates to an epoxy resin composition for molding and a semiconductor device molded by using the same.

## Description

### [Technical Field]

The present invention relates to an epoxy resin composition for molding and a semiconductor device molded by using the same.

### [Background Art]

A resin composition for encapsulation is used as a material that improves the properties and reliability of semiconductor devices by sealing semiconductor elements such as integrated circuits (ICs), large-capacity integrated circuits (LSIs), transistors, and diodes. Recently, as high integration of semiconductors is accelerated in accordance with trends in miniaturization, weight reduction, and high performance of electronic devices, research to improve the performance of materials used for sealing semiconductor devices is continuing in various fields. For example, Japanese Patent Publication No. 2017-197620 relates to an epoxy resin composition for semiconductor encapsulation, comprising an epoxy resin, a phenol resin curing agent and a filler, and discloses a technique for increasing electrical connection reliability by adjusting the content of a filler and the thermal elasticity of a cured product of an epoxy resin composition.

However, a conventional resin composition for semiconductor encapsulation has a problem in that properties enough to satisfy flowability during compression, low shrinkage and swelling inhibition properties, required in the manufacture of epoxy molding compound (EMC), are not provided. Accordingly, there is a need to develop an epoxy resin composition for molding having excellent flowability during compression, low shrinkage and swelling inhibition properties.

### [Detailed Description of Invention]

### [Technical Problem]

The present invention provides an epoxy resin composition for molding having excellent flowability during compression, low shrinkage and swelling inhibition properties, and a semiconductor device molded by using the same.

### [Technical Solution]

The present invention provides an epoxy resin composition comprising an epoxy resin, a curing agent, a filler, and organopolysiloxane, wherein the organopolysiloxane has an epoxy group at both ends and includes an aryl group having 5-8 carbon atoms at a side chain.

### [Advantageous Effects]

The present invention provides an epoxy resin composition for molding, which has excellent flowability during compression, low shrinkage and swelling inhibition properties. The epoxy resin composition according to the present invention can be applied to a compression molding method, and in particular, can be applied as a granular epoxy molding compound (EMC) because of excellent swelling inhibition properties thereof.

### [Best Mode]

Hereinafter, the present invention will be described in detail. However, the present invention is not limited only by the following contents, and each component may be variously modified or optionally mixed as needed. Therefore, it should be understood to include all modifications, equivalents, and substitutes included in the spirit and scope of the present invention.

The "softening point" used herein is measured by a conventional method known in the art, and can be measured, for example, with a dropping point system calorimetry DP70 from Mettler Toledo. The "particle size (D50)" is measured by a conventional method known in the art, and can be measured, for example, by a laser particle size analyzer.

### <Epoxy Resin Composition>

The epoxy resin composition according to the present invention includes an epoxy resin, a curing agent, a filler, and organopolysiloxane. The present invention provides an epoxy resin composition for sealing, which has excellent flowability during compression, low shrinkage and swelling inhibition properties, by using organopolysiloxane having an epoxy group at both ends and containing an aryl group having 5-8 carbon atoms at a side chain.

The epoxy resin composition of the present invention can be manufactured in liquid form, powder form, granule form, or sheet form, and can be used as a sealing material (epoxy molding compound (EMC)) for semiconductor devices or a molding material or fixing material for various electronic parts and automotive parts. In one example, the epoxy resin composition for molding, of the present invention, can be applied for sealing of large-area semiconductor packages that are large in size and thin in thickness, and may be made of granular EMC that can be applied to a compression-type molding process, a C-molding process, or a lamination process.

### Epoxy Resin

The epoxy resin composition of the present invention includes an epoxy resin. The epoxy resin is used as a main resin and reacts with a curing agent to form a three-dimensional network structure after curing, thereby imparting strong and firm adhesive properties and heat resistance to an object to be adhered.

As the epoxy resin, epoxy resin commonly used in the art may be used. Non-limiting examples of a usable epoxy resin include a bisphenol A type epoxy resin, alicyclic type epoxy resin, cresol novolac type epoxy resin, bisphenol F type epoxy resin, bisphenol S type epoxy resin, naphthalene type epoxy resin, anthracene type epoxy resin, tetramethyl biphenyl type epoxy resin, phenol novolac type epoxy resin, bisphenol A novolac type epoxy resin, bisphenol S novolac type epoxy resin, biphenyl novolac type epoxy resin, naphthol novolac type epoxy resin, naphthol phenol coaxial novolac type epoxy resin, naphthol cresol coaxial novolac type epoxy resin, aromatic hydrocarbon form aldehyde resin modified phenol resin type epoxy resin, triphenyl methane type epoxy resin, tetraphenyl ethane type epoxy resin, dicyclopentadiene type epoxy resin, dicyclopentadiene phenol addition reaction type epoxy resin, biphenyl type epoxy resin, phenol aralkyl type epoxy resin, polyfunctional phenolic resin, naphthol aralkyl type epoxy resin, etc., and may include at least one of these epoxy resins.

In one example, the epoxy resin may include formaldehyde, polymers with 1,1'-biphenyl and phenol, glycidyl ether;
4,4-bis(2,3-epoxypropoxy)-3,3,5,5-tetramethyl(1,1-biphenyl); 2,7-naphthalenediol polymer with 2-(chloromethyl)oxirane, ar-benzyl derivatives; or mixtures thereof.

In one example, the epoxy resin may include formaldehyde, polymers with 1,1'-biphenyl and phenol, glycidyl ether;
4,4-bis(2,3-epoxypropoxy)-3,3,5,5-tetramethyl(1,1 -biphenyl); and 2,7-naphthalenediol polymers with 2-(chloromethyl)oxirane, ar-benzyl derivatives. In this case, high flowability required during compression molding can be more effectively secured.

As the epoxy resin, one having an epoxy equivalent weight (EEW) of 100-500 g/eq, for example, 150-300 g/eq, may be used. When the EEW is less than the range stated above, the curing density may be high and moisture resistance may be deteriorated, and when the EEW exceeds the range stated above, the curability may be deteriorated.

As the epoxy resin, one having a softening point of 30-150 °C, for example, 50-130 °C, may be used. When the softening point is less than the range stated above, caking properties may be deteriorated, and when the softening point exceeds the range stated above, non-uniform dispersion may occur during manufacturing.

On the basis of the total weight of the epoxy resin composition, the content of the epoxy resin may be 2-20% by weight, for example, 5-15% by weight. When the content of the epoxy resin is less than the range stated above, adhesiveness, flowability, and formability may be deteriorated, and when the content of the epoxy resin exceeds the range stated above, the reliability of the semiconductor may be deteriorated due to an increase in moisture absorption, and the strength may be lowered due to a relative decrease in the content of fillers.

### Curing Agent

The epoxy resin composition of the present invention includes a curing agent. The curing agent reacts with the epoxy resin to promote curing of the composition.

As the curing agent, a curing agent known in the art to undergo a curing reaction with epoxy resin may be used, and the curing agent may be a phenolic compound having two or more phenolic hydroxyl groups in one molecule. Non-limiting examples of a usable curing agent may include phenol novolac resin, cresol novolac resin, phenol aralkyl resin, polyfunctional phenol compound, etc., and may include one or more of these curing agents.

In one example, the curing agent may include phenol polymer with 4,4-bis(methoxymethyl)1,1-bisphenyl, phenol polymer with hydroxybenzaldehyde, or a mixture thereof.

As the curing agent, one having a hydroxyl equivalent of 90-300 g/eq, for example, 100-200 g/eq, may be used. When the hydroxyl equivalent is less than the range stated above, the reliability in moisture resistance may be deteriorated, and when the hydroxyl equivalent exceeds the range stated above, the curability may be deteriorated.

As the curing agent, one having a softening point of 50-120 °C, for example, 55-90 °C, may be used. When the softening point is less than the range stated above, the caking property may be inferior, and when the softening point exceeds the range stated above, the flowability may be deteriorated.

On the basis of the total weight of the epoxy resin composition, the content of the curing agent may be 2-20% by weight, for example, 2-10% by weight. When the content of the curing agent is less than the range stated above, the curability and formability may be lowered, and when the content of the curing agent exceeds the range stated above, the reliability of the semiconductor may be deteriorated and the strength may be lowered, due to an increase in moisture absorption.

### Filler

The epoxy resin composition of the present invention includes a filler. The filler serves to improve the mechanical properties (e.g., strength) of the epoxy resin composition and lower the moisture absorption.

As the filler, any inorganic filler that is commonly used in the field of electronic materials may be used without particular limitation. In one example, inorganic fillers, such as silica, silica nitride, alumina, aluminum nitride, and boron nitride, may be used, and these may be used alone or in combination of two or more.

The shape of the filler is not particularly limited, and both angular and spherical shapes can be used. Non-limiting examples of the filler that can be used in the present invention include natural silica, synthetic silica, fused silica, etc., and spherical silica particles may be used.

The filler may include two or more types of fillers having different particle sizes. In this case, formability and workability of the epoxy resin composition can be further improved. In one example, the filler may include a first filler having an average particle diameter (D50) of 3.5-20 µm, for example, 3.5-15 µm, and a second filler having an average particle diameter (D50) of 0.1-3 µm, for example, 0.1-1 µm.

On the basis of the total weight of the epoxy resin composition, the content of the filler may be 50-90% by weight, for example, 70-90% by weight. When the content of the filler is less than the range stated above, the moisture absorption amount of the cured product may increase, which may decrease the reliability of a semiconductor device, and when the content of the filler exceeds the range stated above, the flowability may be lowered, and thus, the formability may be deteriorated.

### Organopolysiloxane

The epoxy resin composition of the present invention includes organopolysiloxane. Organopolysiloxane imparts excellent flowability during compression, low shrinkage and swelling inhibition properties to the epoxy resin composition.

As the organopolysiloxane, organopolysiloxane having an epoxy group at both ends and an aryl group having 5-8 carbon atoms at a side chain may be used. In one example, organopolysiloxane having an epoxy group at both ends and a phenyl group (an aryl group having 6 carbon atoms) at a side chain may be used. Due to the epoxy groups located at both ends of the organopolysiloxane, it is possible to secure good compatibility with epoxy resin, and due to the aryl group having strong structure located at the side chain, shrinkage of the resin structure can be reduced during heat curing or when cooled to room temperature after curing.

The organopolysiloxane may be represented by Chemical Formula 1 below: 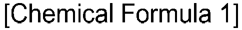 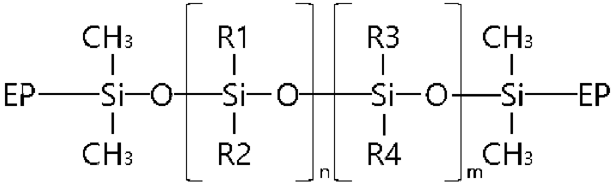 wherein:
EP is an epoxy group;
R1 is a substituted or unsubstituted alkyl group having 1-5 carbon atoms or an alkoxy group having 1-5 carbon atoms;
R2 is an aryl group having 5-8 carbon atoms;
R3 is a substituted or unsubstituted alkyl group having 1-5 carbon atoms, an aryl group having 5-8 carbon atoms, or a cycloalkyl group having 5-10 carbon atoms;
R4 is a substituted or unsubstituted alkyl group having 1-5 carbon atoms or an alkoxy group having 1-5 carbon atoms;
n is an integer from 1 to 50; and
m is an integer from 0 to 50.

In one example, in the above formula, EP is an epoxy group, R1 is a substituted or unsubstituted alkyl group having 1-3 carbon atoms, or an alkoxy group having 1-3 carbon atoms, R2 is a phenyl group, R3 is a substituted or unsubstituted alkyl group having 1-3 carbon atoms, a phenyl group, or a cycloalkyl group having 5-8 carbon atoms, R4 is a substituted or unsubstituted alkyl group having 1-3 carbon atoms, or an alkoxy group having 1-3 carbon atoms, n is an integer from 1 to 50, and m is an integer from 0 to 50.

In one example, in the above formula, EP is an epoxy group, R1 is a methyl group or a methoxy group, R2 is a phenyl group, R3 is a methyl group, a phenyl group, or a cycloalkyl group having 5-8 carbon atoms, R4 is a methyl group or a methoxy group, n is an integer from 1 to 50, and m is an integer from 0 to 50.

In one example, in the above formula, EP is an epoxy group, R1 is a methyl group or a methoxy group, R2 is a phenyl group, R3 is a phenyl group, R4 is a methyl group or a methoxy group, n is an integer from 1 to 50, and m is an integer from 0 to 50.

As the organopolysiloxane, organopolysiloxane having a viscosity (25 °C) of 1,000-50,000 mPa·s and an epoxy equivalent weight (EEW) of 1,000-5,000 g/mol may be used. When the viscosity or EEW is less than the range stated above, sufficient swelling properties may not be secured, and when the viscosity or EEW exceeds the range stated above, the flowability during compression may be deteriorated.

On the basis of the total weight of the epoxy resin composition, the content of the organopolysiloxane may be 0.1-10% by weight, for example, 0.1-3% by weight. When the content of the organopolysiloxane is less than the range stated above, the epoxy resin composition may not have sufficient flowability, low shrinkage and swelling inhibition properties, and when the content of the organopolysiloxane exceeds the range stated above, the curability and strength may be deteriorated.

### Additives

The epoxy resin composition of the present invention may additionally include additives that are commonly used in the composition. Non-limiting examples of usable additives include a catalyst, a coupling agent, an ion catcher, a coloring agent, a release agent, and the like.

A catalyst promotes a curing reaction, and usable examples thereof may include an imidazole-based compound, a naphthalene-based latent catalyst, an amine-based compound, an organometallic compound, an organophosphorus compound, a boron compound, and the like. A coupling agent promotes the bonding between inorganic and organic materials, and amino silane, epoxy silane, etc. may be used. An ion catcher traps and removes impurity ions to reduce corrosion, and an inorganic ion exchanger, such as magnesium aluminum hydroxide carbonate hydrate, may be used. A coloring agent is added to impart a color to the resin composition, and carbon black, bengala, etc. may be used as the coloring agent. A release agent is added to ensure releasability between EMC and a mold, and paraffin wax, carnauba wax, polyethylene wax, ester wax, etc. may be used as the release agent.

The additives may be added within a content range known in the art, and, for example, on the basis of the total weight of the epoxy resin composition, may be included in an amount of 0.01-5% by weight, but is not limited thereto.

The epoxy resin composition according to the present invention can be prepared by a conventional method known in the art, for example, a melt-kneading method using a banbury mixer, a kneader, a roll, a single- or twin-screw extruder, and co-kneader.

The epoxy resin composition of the present invention can be manufactured in powder form, granular form, and the like. In particular, the epoxy resin composition according to the present invention has excellent swelling inhibition properties and can be manufactured in a granular form and applied to a compression molding method.

In one example, a powder-type or granular-type epoxy resin composition can be manufactured by uniformly mixing the above-described components, melting and mixing at a temperature of 80-130 °C by using a heat kneader, cooling to room temperature, and then pulverizing to a powder state, followed by sieving, but not limited thereto.

### <Semiconductor Device and Automotive Parts>

The present invention provides a molded semiconductor device using the above-described epoxy resin composition. The semiconductor device may be a transistor, a diode, a microprocessor, a semiconductor memory, or a power semiconductor.

In addition, the present invention provides an automotive part molded by using the above-described epoxy resin composition. In an example, the epoxy resin composition can be used as a molding material to fix and seal components in an automotive part, and, specifically, a permanent magnet may be inserted into an empty space formed in a rotor core of a vehicle motor, and the epoxy resin composition of the present invention may be filled between the empty space and the permanent magnet to fix the permanent magnet in the rotor core.

A method for molding a semiconductor device or molding an automotive part by using the epoxy resin composition of the present invention may be appropriately selected and performed according to a conventional method in the art, for example, transfer molding, compression molding, injection molding, and the like.

### [Modes of the Invention]

Hereinafter, the present invention will be described in more detail through examples. However, the following examples are only for a better understanding of the present invention, and the scope of the present invention is not limited to the examples in any sense.

### [Examples 1-2]

After blending various components according to the compositions shown in Table 1, the blended product was melted and mixed at a temperature of 100-130 °C by using a melt kneader, cooled to room temperature, and pulverized into powder, followed by sieving, thereby preparing the granular epoxy resin composition of each example.

### [Comparative Examples 1-3]

Except for the compositions shown in Table 1 below, granular epoxy resin compositions of each comparative example were prepared in the same manner as in Examples.

**[Table 1]**

| Component (wt%) | Example 1 | Example 2 | Comparative Example 1 | Comparative Example 2 | Comparative Example 3 |
|---|---|---|---|---|---|
| Epoxy resin 1 | 3.12 | 3.12 | 3.12 | 3.12 | 3.12 |
| Epoxy resin 2 | 1.56 | 1.56 | 1.56 | 1.56 | 1.56 |
| Epoxy resin 3 | 1.56 | 1.56 | 1.56 | 1.56 | 1.56 |
| Curing agent 1 | 1.36 | 1.36 | 1.36 | 1.36 | 1.36 |
| Curing agent 2 | 2.72 | 2.72 | 2.72 | 2.72 | 2.72 |
| Filler 1 | 78 | 78 | 78 | 78 | 78 |
| Filler 2 | 10 | 10 | 10 | 10 | 10 |
| Organopolysiloxane 1 | 0.5 | | | | |
| Organopolysiloxane 2 | | 0.5 | | | |
| Organopolysiloxane 3 | | | 0.5 | | |
| Organopolysiloxane 4 | | | | 0.5 | |
| Organopolysiloxane 5 | | | | | 0.5 |
| Catalyst | 0.18 | 0.18 | 0.18 | 0.18 | 0.18 |
| Coupling agent 1 | 0.45 | 0.45 | 0.45 | 0.45 | 0.45 |
| Coupling agent 2 | 0.05 | 0.05 | 0.05 | 0.05 | 0.05 |
| Ion catcher | 0.1 | 0.1 | 0.1 | 0.1 | 0.1 |
| Coloring agent | 0.35 | 0.35 | 0.35 | 0.35 | 0.35 |
| Release agent | 0.05 | 0.05 | 0.05 | 0.05 | 0.05 |
| Total | 100.00 | 100.00 | 100.00 | 100.00 | 100.00 |

| | | | | | |
|---|---|---|---|---|---|
| Epoxy resin 1: Crystalline epoxy resin (4,4-bis(2,3-epoxypropoxy)-3,3,5,5-tetramethyl(1,1-biphenyl), Cas no.: 0085954-11-6; Mw: 354 g/mol) Epoxy resin 2: Multi-aromatic epoxy resin (formaldehyde, polymer with 1,1'-biphenyl and phenol, glycidyl ether, Cas no.: 1201169-35-8; Mw: 8,397 g/mol) Epoxy resin 3: Epoxy resin containing naphthalene backbone (2,7-Naphthalenediol polymer with 2-(chloromethyl)oxirane, ar-benzyl derivs, Cas no.: 1394035-93-8; viscosity (150 °C): 50 mPa·s) Curing agent 1: Multi-aromatic phenol resin (Phenol polymer with hydroxybenzaldehyde, Cas no.: 0205830-20-2; viscosity (150 °C): 105 mPa·s) Curing agent 2: Multifunctional phenolic resin (Phenol polymer with 4,4-bis(methoxymethyl)1,1-bisphenyl, Cas no. 0106466-55-1; Mw: 521 g/mol) Filler 1: Silicon dioxide (Spherical silica, D50: 12 µm) Filler 2: Silicon dioxide (Spherical silica, D50: 0.6 µm) Organopolysiloxane 1: Modified siloxane having an epoxy group at both ends and a phenyl group at a side chain (viscosity (25 °C): 1,280 mPa·s; epoxy equivalent weight (EEW): 1,250 g/mol; Momemtive Performance Materials Inc., XF42-D0027 LV cut) Organopolysiloxane 2: Modified siloxane having an epoxy group at both ends and a phenyl group at a side chain (viscosity (25 °C): 45,000 mPa·s; EEW: 4,320 g/mol; Momemtive Performance Materials Inc., XF42-D0027-HH) Organopolysiloxane 3: Polyether-modified siloxane containing an epoxy group at a side chain (viscosity (25 °C): 4,500 mPa·s; EEW: 4,300 g/mol; SHIN-ETSU Chemical Co., Ltd., KF-1002) Organopolysiloxane 4: Modified siloxane having an epoxy group at both ends (viscosity (25 °C): 120 mPa·s; EEW: 2,700 g/mol; SHIN-ETSU Chemical Co., Ltd., X-22-163C) Organopolysiloxane 5: Modified siloxane containing a phenyl group at a side chain (viscosity (25 °C): 3,000 mPa·s; SHIN-ETSU Chemical Co., Ltd., F5W-0-3,000cs) Catalyst: 5-Methyl-2-phenylimidazole-4-methanol Coupling agent 1: N-Phenyl-3-aminopropyltrimethoxysilane Coupling agent 2: (3-mercaptopropyl)trimethoxysilane Ion catcher: Magnesium aluminum hydroxide carbonate hydrate Coloring agent: Carbon Black Release agent: Ester wax | | | | | |

### [Evaluation of Properties]

The properties of the epoxy resin compositions prepared in Examples and Comparative Examples were measured as follows, and the results are shown in Table 2 below.

### Spiral flow

After molding the epoxy resin compositions prepared according to Examples and Comparative Examples by using a spiral flow mold in a heat transfer molding machine (pressure: 70 kg/cm²; temperature: 175 °C; curing time: 200 seconds), the flowability of each product was measured.

### Gel time

After putting the epoxy resin compositions prepared according to Examples and Comparative Examples in a gel timer and spreading them widely and evenly, the gel time of each product measured.

### Flexural strength

The flexural strength was measured according to ASTM D638, D256, and D790.

### Flexural modulus

After molding the epoxy resin compositions prepared according to Examples and Comparative Examples by using a sample production mold (125 mm in width, 12.5 mm in length, 6 mm in thickness) in a heat transfer molding machine (pressure: 70 kg/cm²; temperature: 175 °C; curing time: 200 seconds), and then curing in an oven at 175 °C for 4 hours, the flexural modulus was measured according to a universal testing machine (UTM).

### Mold Shrinkage

After molding the epoxy resin compositions prepared according to Examples and Comparative Examples by using a sample production mold (125 mm in width, 12.5 mm in length, 6 mm in thickness) in a heat transfer molding machine (pressure: 70 kg/cm²; temperature: 175 °C; curing time: 200 seconds), and then curing in an oven at 175 °C for 4 hours, the length of the shrunk sample was measured by using Vernier calipers.

### Swelling property

After each of the epoxy resin compositions prepared according to Examples and Comparative Examples was left on a hot plate in a vacuum state at 175 °C and 640 (torr) for 5 minutes, the swelling height of a sample in a vial (2.0 g) was measured, and the change rate was evaluated.

### Flowability during Compression

After each of the epoxy resin compositions prepared according to Examples and Comparative Examples was placed on a 165 °C hot plate, and a load of 1,074 g was applied thereto for 5 minutes, the flowability during compression was evaluated by checking an spread area of each of the epoxy resin compositions.

**[Table 2]**

| Property | Unit | Example 1 | Example 2 | Comparative Example 1 | Comparative Example 2 | Comparative Example 3 |
|---|---|---|---|---|---|---|
| Spiral flow | Inch | 65 | 59 | 63 | 60 | 51 |
| Gel time | Second | 63 | 61 | 61 | 59 | 63 |
| Flexural strength | Kgf/mm² | 15 | 15 | 15 | 12 | 13 |
| Flexural modulus | Kgf/mm² | 2420 | 2350 | 2335 | 2361 | 2441 |
| Mold Shrinkage | % | 0.18 | 0.20 | 0.26 | 0.28 | 0.20 |
| Swelling property | % | 18 | 7 | 73 | 87 | 7 |
| Flowability during compression | cm² | 35 | 33 | 32 | 33 | 14 |

As indicated in Table 2, the epoxy resin compositions of Examples 1 and 2 containing organopolysiloxanes (organopolysiloxane 1 and 2) according to the present invention showed excellent properties in all measurement items. However, the epoxy resin compositions of Comparative Examples 1-3 using organopolysiloxanes (organopolysiloxanes 3-5) deviating from the range of the present invention showed poor properties, compared to the examples, in all measurement items.

Specifically, the epoxy resin compositions of Comparative Example 1, comprising a polyether-modified siloxane (organopolysiloxane 3) containing an epoxy group at a side chain, rather than at an end, and Comparative Example 2, comprising an epoxy-modified siloxane (organopolysiloxane 4) containing no phenyl group at a side chain, showed severe shrinkage and swelling during molding. In addition, the epoxy resin composition of Comparative Example 3, comprising phenyl-modified siloxane (organopolysiloxane 5) having no epoxy group at both ends, showed poor flowability during compression.

### [Industrial Applicability]

The present invention provides an epoxy resin composition for molding having excellent flowability during compression, low shrinkage and swelling inhibition properties, and a semiconductor device molded by using the same.

## Claims

1. An epoxy resin composition comprising an epoxy resin, a curing agent, a filler, and an organopolysiloxane,
wherein the organopolysiloxane has an epoxy group at both ends and an aryl group having 5-8 carbon atoms at a side chain.

2. The epoxy resin composition as claimed in claim 1, wherein the epoxy resin has an epoxy equivalent weight (EEW) of 100-500 g/eq, and a softening point of 30-150 °C.

3. The epoxy resin composition as claimed in claim 1, wherein the curing agent has a hydroxyl equivalent of 90-300 g/eq, and a softening point of 50-120 °C.

4. The epoxy resin composition as claimed in claim 1, wherein the organopolysiloxane is represented by Chemical Formula 1 below: 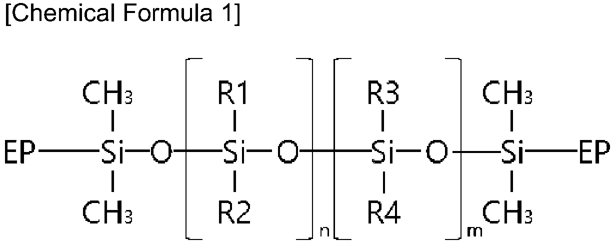 wherein:
EP is an epoxy group;
R1 is a substituted or unsubstituted alkyl group having 1-5 carbon atoms or an alkoxy group having 1-5 carbon atoms;
R2 is an aryl group having 5-8 carbon atoms;
R3 is a substituted or unsubstituted alkyl group having 1-5 carbon atoms, an aryl group having 5-8 carbon atoms, or a cycloalkyl group having 5-10 carbon atoms;
R4 is a substituted or unsubstituted alkyl group having 1-5 carbon atoms or an alkoxy group having 1-5 carbon atoms;
n is an integer from 1 to 50; and
m is an integer from 0 to 50.

5. The epoxy resin composition as claimed in claim 1, wherein the organopolysiloxane has a viscosity (25 °C) of 1,000-50,000 mPa·s, and an epoxy equivalent weight (EEW) of 1,000-5,000 g/mol.

6. The epoxy resin composition as claimed in claim 1, wherein, on the basis of the total weight of the epoxy resin composition, the epoxy resin composition comprises 2-20% by weight of the epoxy resin, 2-20% by weight of the curing agent, 50-90% by weight of the filler, and 0.1-10% by weight of the organopolysiloxane.

7. A semiconductor device molded by using the epoxy resin composition according to any one of claims 1 to 6.
